# EUROPEAN PATENT APPLICATION

(11) **EP 4 654 255 A1**
(43) Date of publication of application: **26.11.2025**
(21) Application number: 25177054.1
(22) Date of filing: 16.05.2025
(51) Int. Cl.: H01L 21/683, H01L 21/687

(54) **WAFER HANDLING END EFFECTOR**

(30) Priority: 21.05.2024 US 202463650073 P
(71) Applicant: ASM IP Holding B.V., 1322 AP Almere (NL)
(72) Inventor: KOTHARI, Nimit, 1322 AP Almere (NL)
(74) Representative: V.O.

(57) **Abstract**

An end effector for supporting a wafer is disclosed. The end effector comprises a main body, a vacuum line formed in the main body, a first support arranged for contacting an inner area of a wafer, at least one opening within a boundary of the first support in communication with the vacuum line, and at least one second support arranged for contacting an outer edge of a wafer.

## Description

### FIELD OF INVENTION

The present disclosure relates to wafer handling in semiconductor processing. More specifically, it relates to an end effector for handling wafers.

### BACKGROUND OF THE DISCLOSURE

Semiconductor processing involves various processes performed on substrates, such as for example, wafers, that are aligned with one another in order to manufacture the semiconductor devices.

With the advances in semiconductor industry, increase in number of chips produced and increase in throughput may become important factors in order to lower the cost of manufacturing. This may be enabled by processing larger sized substrates and/or processing a plurality of substrates at a time such as for example, in batches.

For some of the processes, the plurality of substrates may be subjected to an increased heat. This may lead to a certain degree of warp to occur at the circumferential edge of the substrates. This may then require a careful handling of such warped substrates in further processes in the manufacturing, particularly when they are treated in batches.

Certain wafer types are susceptible to warp even if not subjected to increased heat and may have particular handling requirements, for example a wafer which has been subjected to back grinding leaving a thin inner area and a thicker edge.

Therefore, there may be a need for an improved handling of substrates.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It may be an object of the present disclosure to provide an end effector for improving handling of warped substrates. It may be a further object of the present disclosure to provide an end effector capable of handling both warped substrates and standard substrates.

In a first aspect, the present disclosure relates to an end effector.

The end effector may comprise a main body, a vacuum line formed in the main body, a first support arranged for contacting an inner area of a wafer, at least one opening within a boundary of the first support in communication with the vacuum line, and at least one second support arranged for contacting an outer edge of a wafer.

The first support arranged for contacting an inner area of a wafer may comprise a central raised area and at least one circular raised area arranged concentric with the central raised area such that when a wafer is supported on the first support, an enclosed volume is formed between the wafer and the first support.

The first support arranged for contacting an inner area of a wafer may comprise a central raised area and at least two circular raised areas arranged concentric with the central raised area such that when a wafer is supported on the first support, an enclosed volume is formed between the wafer and the first support.

The vacuum line may be in communication with the enclosed volume.

The end effector may comprise a first vacuum line in communication with a first enclosed volume between the central raised area and an adjacent concentric circular raised area, and a second vacuum line in communication with a second enclosed volume between two concentric circular raised areas.

A height of the at least one second support may be less than a height of the first support.

The main body may have a fork shape with a main part and two projecting parts, and the at least one second support may comprise respective second support parts on the two projecting parts and a second support part on the main part.

The at least one second support may be generally arc shaped.

The at least one second support may be circular.

The at least one second support may project from a plane of the end effector while having an angle with the plane of the end effector which is between 1 and 90 degrees. The angle may be between 10 and 80 degrees, between 20 and 70 degrees, between 30 and 60 degrees, between 40 and 50 degrees.

The end effector may comprise at least two second supports arranged for contacting an outer edge of a wafer, and each of the at least two second supports may comprise a respective piezoelectric actuator configured to cause the respective second support to move between a wafer gripping position and a wafer release position.

In a wafer gripping position, the second support may be closer to the first support than when in a wafer release position.

In a wafer gripping position, the second support may be further away from the first support than when in a wafer release position.

In a wafer gripping position, the second support may have the same distance from the first support as when in a wafer release position.

The main body may have a fork shape with a main part and two projecting parts, and at least one second support comprising a piezoelectric actuator may be disposed on one projecting part, and at least one second support comprising a piezoelectric actuator may be disposed on the other projecting part.

According to a second aspect of the present invention there is provided a wafer handling apparatus comprising a wafer handling robot, an end effector according to the first aspect, a vacuum pump connected to the vacuum line of the end effector, and a control module configured to receive a wafer type of a wafer to be handled by the wafer handling apparatus and to set the vacuum pump to an on status or an off status depending on the wafer type.

The end effector may be an end effector according to the first aspect which comprises a piezoelectric actuator and the control module may be additionally configured to control a gripping status of the piezoelectric actuator depending on the wafer type.

It may be an advantage of embodiments of the present invention that wafer handling may be improved, particularly for warped wafers.

It may be an advantage that reliability of wafer handling may be increased; such that wafer breakage or cracking may be reduced.

### BRIEF DESCRIPTION OF THE DRAWING FIGURES

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

Like reference numbers will be used for like elements in the drawings unless stated otherwise. Reference signs in the claims shall not be understood as limiting the scope.
Figure 1a is a plan view of a first example embodiment of an end effector according to the present invention;
Figure 1b is a plan view of a second example embodiment of an end effector according to the present invention;
Figure 1c is a plan view of a third example embodiment of an end effector according to the present invention;
Figures 2a to 2f are side views of end effectors according to embodiments of the present invention;
Figure 3 is a side view of an end effector according to embodiments of the present invention;
Figures 4a and 4b are side views of an end effector comprising piezoelectric actuators according to embodiments of the present invention;
Figure 5 is a schematic view of a wafer handling apparatus according to embodiments of the present invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

As used herein, the term "substrate" may refer to any underlying material or materials, including any underlying material or materials that may be modified, or upon which, a device, a circuit, or a film may be formed. The "substrate" may be continuous or non-continuous; rigid or flexible; solid or porous; and combinations thereof. The substrate may be in any form, such as a powder, a plate, or a workpiece. Substrates in the form of a plate may include wafers in various shapes and sizes. Substrates may be made from semiconductor materials, including, for example, silicon, silicon germanium, silicon oxide, gallium arsenide, gallium nitride and silicon carbide.

As examples, a substrate in the form of a powder may have applications for pharmaceutical manufacturing. A porous substrate may comprise polymers. Examples of workpieces may include medical devices (for example, stents and syringes), jewelry, tooling devices, components for battery manufacturing (for example, anodes, cathodes, or separators) or components of photovoltaic cells, etc.

A continuous substrate may extend beyond the bounds of a process chamber where a deposition process occurs. In some processes, the continuous substrate may move through the process chamber such that the process continues until the end of the substrate is reached. A continuous substrate may be supplied from a continuous substrate feeding system to allow for manufacture and output of the continuous substrate in any appropriate form.

Non-limiting examples of a continuous substrate may include a sheet, a non-woven film, a roll, a foil, a web, a flexible material, a bundle of continuous filaments or fibers (for example, ceramic fibers or polymer fibers). Continuous substrates may also comprise carriers or sheets upon which non-continuous substrates are mounted.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and sub-combinations of the various processes, systems, and configurations, and other features, functions, acts, and/or properties disclosed herein, as well as any and all equivalents thereof.

Reference throughout the specification to "embodiments" in various places are not necessarily all referring to the same embodiment, but may. Furthermore, the particular features, structures or characteristics maybe combined in any suitable manner, as would be apparent to one of the ordinary skill in the art from the disclosure, in one or more embodiments.

Reference throughout the specification to "some embodiments" means that a particular structure, feature step described in connection with these embodiments is included in some of the embodiments of the present invention. Thus, phrases appearing such as "in some embodiments" in different places throughout the specification are not necessarily referring to the same collection of embodiments, but may.

Reference throughout this specification to "one embodiment" or "an embodiment" means that a particular feature, structure, or characteristic described in connection with the embodiment is included in at least one embodiment of the present disclosure. Thus, appearances of the phrases "in one embodiment" or "in an embodiment" in various places throughout this specification are not necessarily all referring to the same embodiment, but may.

It is to be noticed that the term "comprising", as used herein, should not be interpreted as being restricted to the means listed thereafter. It does not exclude other elements or steps. It is thus, to be interpreted as specifying the presence of the stated features, steps or components as referred to. However, it does not prevent one or more other steps, components, or features, or groups thereof from being present or being added.

The terms first, second, third, and the like in the description and in the claims, are used for distinguishing between similar elements. They are not necessarily used for describing a sequence, either temporally, spatially, in ranking, or in any other manner. It is to be understood that the terms so used are interchangeable under appropriate circumstances and that the embodiments of the disclosure described herein are capable of operation in other sequences than described or illustrated herein.

The following terms are provided only to help in the understanding of the disclosure.

As used herein and unless provided otherwise, the term "warped substrate or a warped wafer" may refer to substrates or wafers having a deviation of their geometry from their initial state of flatness.

As used herein and unless provided otherwise, the term "central portion of the wafer" may refer to a portion of the wafer that may be covered extending away from its center by at least 2/3 of its radius.

The disclosure will now be described by a detailed description of several embodiments of the disclosure. It is clear that other embodiments of the disclosure can be configured according to the knowledge of persons skilled in the art in the absence of departure from the technical teaching of the disclosure. The disclosure is limited only by the terms of the claims included herein.

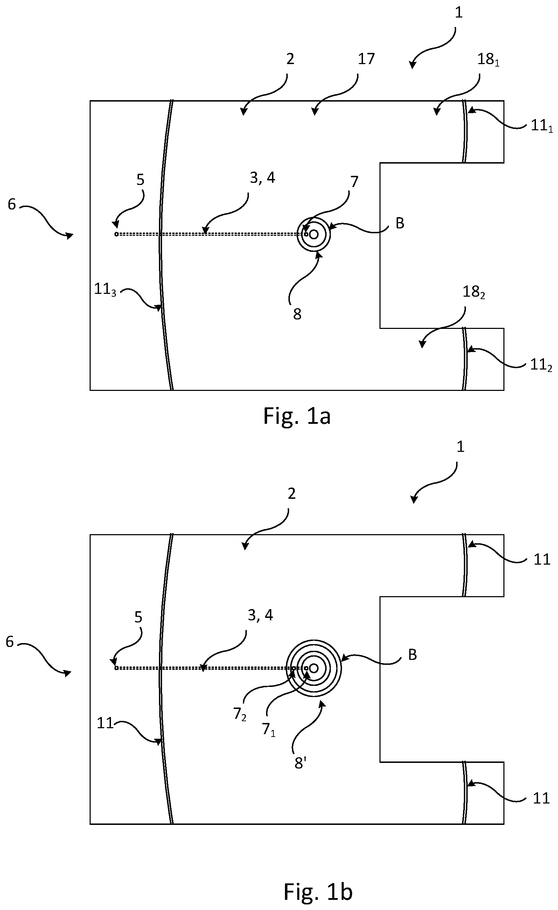

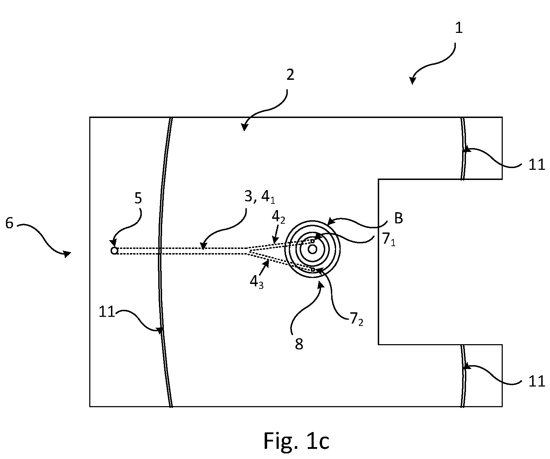

Referring to Figures 1 to 3, an end effector 1 according to an embodiment of the present disclosure comprises a main body 2. The main body 2 is preferably substantially planar. The end effector may be configured to removably attach to a wafer handling robot (not shown). A wafer handling robot may transfer wafers between positions such as, for example, storage cassette, a boat, a susceptor, a cleaning station, or other wafer positions in a substrate processing apparatus, by supporting a wafer on the end effector 1. The end effector 1 may be generally fork shaped having a main part and two projecting parts. The end effector 1 may be generally disc shaped or polygonal.

The end effector 1 comprises a vacuum line 3 formed in the main body 2. The vacuum line 3 may comprise only one channel 4. The vacuum line 3 may comprise a main channel and two or more secondary channels branching off from the main channel. The vacuum line 3 may be a channel 4 in the main body 2 having an opening 5 at an end 6 of the end effector 1 at which the end effector may attach to a wafer handling robot and an opening 7 at a location at which a first support 8 is provided. The opening 5 may attach to a vacuum pump so as to evacuate the channel 4 when the opening 7 is closed.

The end effector 1 comprises a first support 8 for contacting an inner area of a wafer. The first support 8 may be positioned so as to be capable of aligning with a centre of a wafer to be supported on the end effector 1. The first support 8 may be positioned such that the opening 7 is within an outer boundary B of the first support. For example, the first support 8 may comprise a central circular raised area, or projection, 8₁ and a concentric circular raised area, or projection, 8₂ being centred on the central circular projection 8₁ and the opening 7 may be provided between the central projection 8₁ and the concentric projection 8₂. Referring to Figure 1b, the first support 8 may comprise a central circular raised area, or projection, 8₁, a first concentric circular raised area, or projection, 8₂ and a second concentric circular raised area, or projection, 8₃, the first and second circular projections 8₂ and 8₃ being centred on the central projection 8₁, the first concentric circular projection 8₂ being positioned between the central circular projection 8₁ and the second concentric circular projection 8₃. The vacuum line 3 may have a first opening 7₁ located between the central projection 8₁ and the first concentric projection 8₂ and a second opening 72 located between the first concentric projection 8₂ and the second concentric projection 8₃. Referring to Figure 1c, the vacuum line 3 may comprise a main channel 41 and at least two secondary channels 4₂, 4₃ which branch off from the main channel 41 and connect with first and second openings 7₁, 7₂ respectively. The first support preferably comprises an elastically deformable material, for example (but not limited to)
polytetrafluoroethylene (PTFE).

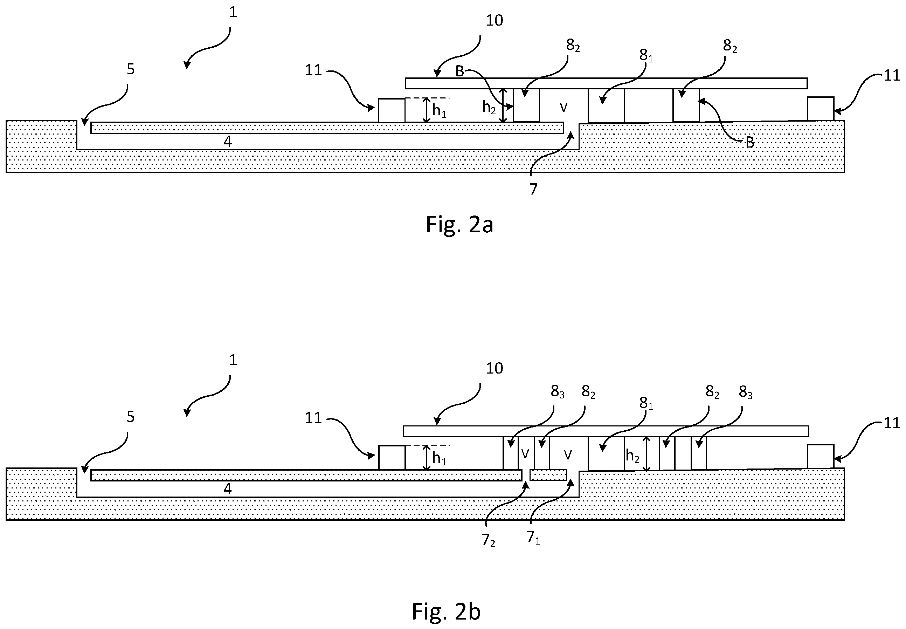

Referring to Figures 2a and 2b, when a wafer 10 is supported by the first support 8, openings 7, 7₁, 7₂ may be closed off for a volume V above the end effector 1 which is bounded by the wafer 10 and the first support 8. That is, no air may enter the channel 4 through the opening 7, 7₁, 7₂, once the volume V is evacuated. This can create a vacuum suction effect causing the wafer 10 to be held in contact with the end effector 1 by more than just the normal reaction of the first support 8 to the force of gravity caused by the mass of the wafer 10. By holding the wafer 10 with a vacuum force, the end effector 1 may be able to move at a greater velocity than when the vacuum force is not provided, as the vacuum force can help to prevent slipping of the wafer 10 on the end effector 1 when the end effector 1 accelerates or decelerates.

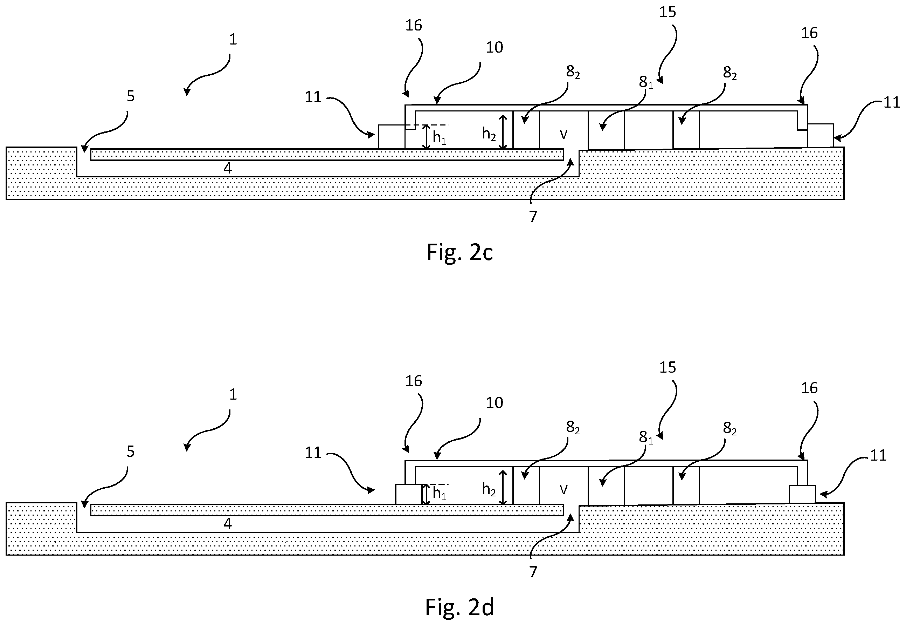

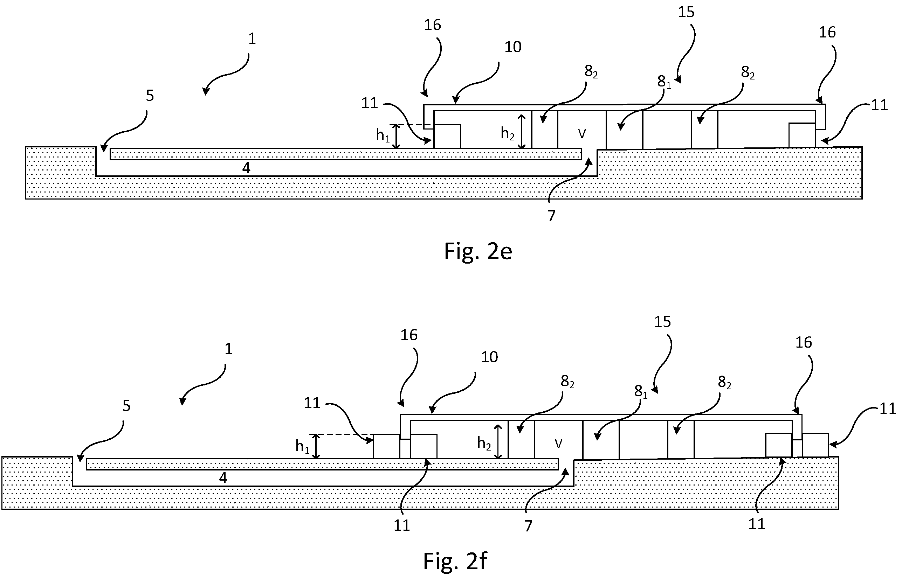

The end effector 1 comprises at least one second support 11 arranged for contacting an outer edge of a wafer. The second support 11 may comprise a raised area, or projection. The second support 11 has a height h1 which may be less than a height h2 of the first support 8. The second support 11 may comprise, for example, an elastically deformable material such as PTFE or a ceramic such as alumina. Referring to Figures 2a and 2b, a wafer 10 which is flat, having little or no back grinding, may be supported only by the first support 8 due to the height difference in the first support 8 and the second support 11. Referring to Figures 2c to 2e, a wafer 10 which has been subjected to back grinding leaving a relatively thin inner area 15 and a relatively thicker outer edge 16 may be supported by the first support 8 in an inner area 15 of the wafer and by the second support 11 at the edge 16. The wafer 10 may be supported by contacting the second support 11 outside the outer edge 16 (Figure 2c). The wafer 10 may be supported by contacting the second support 11 at the bottom of the outer edge 16 (Figure 2d). The wafer 10 may be supported by contacting the second support 11 inside the outer edge 16 (Figure 2e). The wafer 10 may be supported by contacting the second support 11 inside the outer edge 16 and outside the outer edge (Figure 2f).

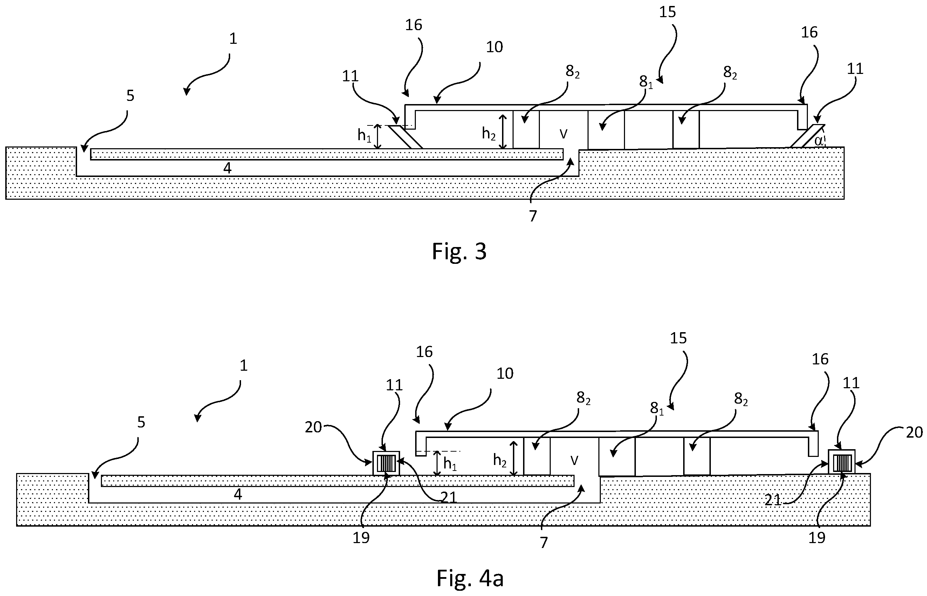

Referring to Figure 3, the second support 11 may project from the end effector 1 at an angle α to the plane of the end effector which is less than 90 degrees. This can allow for wafers of different diameters to be supported using the same end effector 1.

Referring again to Figure 1a, the end effector 1 may have a fork shape with a main part 17 and two projecting parts 181, 182 and the at least one second support 11 may comprise respective second support parts 11₁, 11₂ on the two projecting parts and a second support part 11₃ on the main part.

The at least one second support 11 may be generally arc shaped. For example, the at least one second support 11 may comprise a plurality of second supports 11 each being arc shaped and being centred on the first support 8. The at least one second support 11 may comprise a first set of second supports 11 each being arc shaped and being centred on the first support 8 at a first distance from the first support 8 and a second set of second supports 11 each being arc shaped and being centred on the first support 8 at a second distance from the first support 8, the second distance being different from the first distance, such that an edge 16 of a wafer 10 may be supported between the first and second set of second supports 11. The at least one second support 11 may be a single second support which is circular and unbroken, centred on the first support 8. The at least one second support 11 may comprise two second supports each being circular and unbroken, centred on the first support 8 and each having a different radius such that such that an edge 16 of a wafer 10 may be supported between the two second supports.

The end effector 1 may comprise at least two second supports 11 and the at least two second supports may be moveable between a wafer gripping position and a wafer release position. Movement of the second supports 11 may be achieved by including piezoelectric actuators 19 in each of the second supports 11. By applying a voltage to the piezoelectric actuators, the actuators expand or contract, causing the second supports to move.

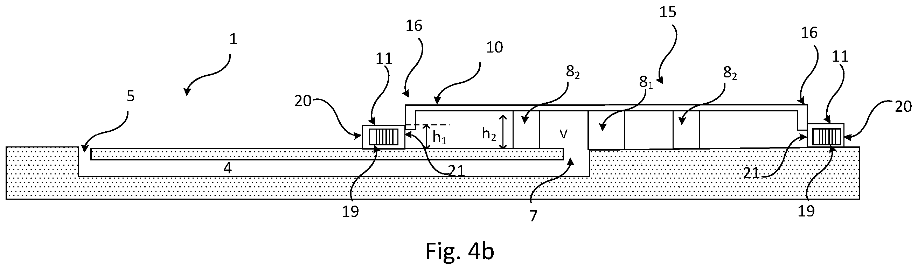

For example, referring to Figures 4a and 4b, the second supports 11 may each have an inward facing edge 21 and an outward facing edge 20, the inward facing edge 21 being facing towards the first support 8 and the outward facing edge 20 being facing away from the first support 8. The second supports 11 may be fixed such that the outward facing edge 20 does not move. When voltage is applied to the piezoelectric actuator 19 the second support may expand in the direction towards the first support 8 and, since the outward facing edge 20 is fixed, the inward facing edge 21 moves so that the distance between the inward facing edge 21 and the first support 8 is decreased (Figure 4b), for example to a distance sufficient to grip an edge 16 of a wafer 10. This can allow the end effector 1 to adopt a wafer gripping position and a wafer release position. In some embodiments, the inward facing edge 21 may be fixed and the second support 11 may expand in the direction away from the first support 8 and the wafer may be gripped in a position similar to that shown in Figure 2e. In some embodiments, the second support 11 may be fixed to the end effector 1 at a bottom edge and the piezoelectric actuator 19 may be oriented so as to expand and contract in a direction away from the plane of the end effector 1 when voltage is applied to the piezoelectric actuator 19 and the wafer may be gripped in a position similar to that shown in Figure 2d. Thus a distance between the first support 8 and the second support 11 does not change when the end effector is in the wafer gripping or wafer release positions.

In some embodiments, the main body of the end effector 1 has a fork shape with a main part 17 and two projecting parts 18₁, 18₂, and at least one second support 11 comprising a piezoelectric actuator 19 is disposed on one projecting part 18₁, and at least one second support 11 comprising a piezoelectric actuator 19 is disposed on the other projecting part 18₂.

The piezoelectric actuators 19 may be controlled by a voltage applied through connection wires (not shown) routed through the end effector 1.

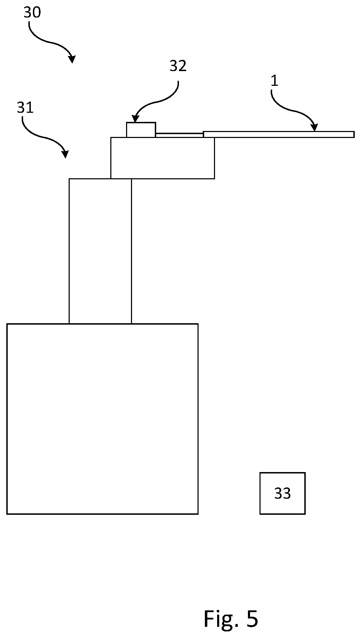

Referring to Figure 5, embodiments of the present invention provide a wafer handling apparatus 30 comprising a wafer handling robot 31, an end effector 1, a vacuum pump 32 connected to the vacuum line of the end effector 1, and a control module 33 configured to receive a wafer type of a wafer to be handled by the wafer handling apparatus and to set the vacuum pump to an on status or an off status depending on the wafer type. The wafer handling apparatus 30 may be comprised in a semiconductor processing apparatus (not shown) and control module 33 may receive a wafer type from a central control module of the semiconductor processing apparatus. The wafer handling apparatus control module 33 may be configured to set the vacuum pump to an on status if the wafer type is a normal flat wafer type and to set the vacuum pump to an off status if the wafer type is a warped wafer type, for example a wafer than has been subjected to back grinding. This can allow wafer handling to be adapted to different wafer types. The control module 33 may be configured to control a position of the wafer handling robot 31 in addition to the vacuum pump status, for example to cause the wafer handling robot 31 to move to a wafer pickup position, to turn the vacuum pump on and to pick up a wafer, to move the wafer to a wafer destination, and to turn the vacuum pump off.

The end effector may be an end effector comprising piezoelectric actuators 19 in the second supports 11 and the control module 33 may be additionally configured to control a gripping status of the piezoelectric actuators 19 depending on the wafer type. For example, the wafer handling apparatus control module 33 may be configured to set the piezoelectric actuators 19 to a release status regardless of wafer type, to cause the wafer handling robot to move to a wafer pickup location, to pick up the wafer by supporting the wafer on the first support, and to set the piezoelectric actuators 19 to a gripping status if the wafer type is a warped wafer type.

Reference throughout this specification to "one embodiment" or "an embodiment" means that a particular feature, structure or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, it is noted that particular features, structures, or characteristics of one or more embodiments may be combined in any suitable manner to form new, not explicitly described embodiments. The subject matter of the present disclosure includes all novel and nonobvious combinations and subcombinations of the various processes, systems, and configurations, and other features, functions, acts, and/or properties disclosed herein, as well as any and all equivalents thereof.

## Claims

1. An end effector for supporting a wafer comprising a main body, a vacuum line formed in the main body, a first support arranged for contacting an inner area of a wafer, at least one opening within a boundary of the first support in communication with the vacuum line, and at least one second support arranged for contacting an outer edge of a wafer.

2. An end effector according to claim 1, wherein the first support arranged for contacting an inner area of a wafer comprises a central raised area and at least one circular raised area arranged concentric with the central raised area such that when a wafer is supported on the first support, an enclosed volume is formed between the wafer and the first support.

3. An end effector according to claim 1, wherein the first support arranged for contacting an inner area of a wafer comprises a central raised area and at least two circular raised areas arranged concentric with the central raised area such that when a wafer is supported on the first support, an enclosed volume is formed between the wafer and the first support.

4. An end effector according to claim 2 or 3, wherein the vacuum line is in communication with the enclosed volume.

5. An end effector according to claim 3, comprising a first vacuum line in communication with a first enclosed volume between the central raised area and an adjacent concentric circular raised area, and a second vacuum line in communication with a second enclosed volume between two concentric circular raised areas.

6. An end effector according to any one of the preceding claims 1, wherein a height of the at least one second support is less than a height of the first support.

7. An end effector according to any one of the preceding claims, wherein the main body has a fork shape with a main part and two projecting parts, wherein the at least one second support comprises respective second support parts on the two projecting parts and a second support part on the main part.

8. An end effector according to any one of the preceding claims, wherein the at least one second support is generally arc shaped.

9. An end effector according to any one of claims 1-6, wherein the at least one second support is circular.

10. An end effector according to any one of claims 1-9, wherein the at least one second support projects from a plane of the end effector while having an angle with the plane of the end effector which is between 1 and 90 degrees.

11. An end effector according to any one of claims 1-10, comprising at least two second supports arranged for contacting an outer edge of a wafer, wherein each of the at least two second supports comprises a respective piezoelectric actuator configured to cause the respective second support to move between a wafer gripping position and a wafer release position.

12. An end effector according to claim 11, wherein when in a wafer gripping position, a second support is closer to the first support than when in a wafer release position.

13. An end effector according to claim 11, wherein when in a wafer gripping position, a second support is further away from the first support than when in a wafer release position.

14. An end effector according to claim 11, wherein when in a wafer gripping position, a second support has the same distance from the first support as when in a wafer release position.

15. An end effector according to claim 11, wherein the main body has a fork shape with a main part and two projecting parts, wherein at least one second support comprising a piezoelectric actuator is disposed on one projecting part, and at least one second support comprising a piezoelectric actuator is disposed on the other projecting part.

16. A wafer handling apparatus comprising a wafer handling robot, an end effector according to any preceding claim, a vacuum pump connected to the vacuum line of the end effector, and a control module configured to receive a wafer type of a wafer to be handled by the wafer handling apparatus and to set the vacuum pump to an on status or an off status depending on the wafer type.

17. A wafer handling apparatus according to claim 16 wherein the end effector is an end effector according to any of claims 11 to 15, wherein the control module is additionally configured to control a gripping status of the piezoelectric actuator depending on the wafer type.
